# EUROPEAN PATENT APPLICATION

(11) **EP 4 089 451 A1**
(43) Date of publication of application: **16.11.2022**
(21) Application number: 21173032.0
(22) Date of filing: 10.05.2021
(51) Int. Cl.: G02B 6/12, H01L 31/105

(54) **PHOTODETECTOR APPARATUS AND METHOD OF DETECTING LIGHT**

(71) Applicant: Max-Planck-Gesellschaft zur Förderung der Wissenschaften e.V., 80539 München (DE); University of Toronto, Toronto, Ontario M5S 1A1 (CA)
(72) Inventor: LIN, Yiding, 06120 Halle (DE); YONG, Zheng, Toronto, Ontario M5S 1A1 (CA); MAK, Jason, Toronto, Ontario M5S 1A1 (CA); SACHER, Wesley, Toronto, Ontario M5S 1A1 (CA); POON, Joyce, 06120 Halle (DE)
(74) Representative: v. Bezold & Partner Patentanwälte - PartG mbB

(57) **Abstract**

A photodetector apparatus 100, being configured for detecting light in the visible or infrared spectrum, comprises a substrate 30, a waveguide 20, a detector section 10, a first contact section 50 and a second contact section 52. The substrate 30 has a substrate surface 32 and a cladding layer 40. The waveguide 20 is arranged above the substrate surface 32 in the cladding layer 40 and is adapted for guiding light. The detector section 10 comprises a p-doped region 12, 14 and a n-doped region 16, 18, and the detector section 10' is arranged for producing charge carriers by the light guided in the waveguide 20. The first contact section 50 is connected to the p-doped region 12, 14 and the second contact section 52 is connected to the n-doped region 16, 18, the first and second contact sections 50, 52 being connectable to a measuring device for measuring an electrical signal based on the charge carriers produced by the light. The waveguide 20 and the detector section 10 are spaced apart by a portion of the cladding layer 40 with a mutual distance such that optical power of the light guided in the waveguide 20 can be gradually transferred from the waveguide 20 to the detector section 10. Furthermore, a method of detecting light in the visible or infrared spectrum is described.

## Description

### Field of the invention

The invention relates to a photodetector and a method of detecting light, in particular for detecting light in the visible or infrared spectrum. Applications of the invention are available for instance in optical measurements, light detection and integrated photonics, e.g., in the fields of neural probes and quantum optics.

### Background of the invention

In the present specification, reference is made to the following prior art illustrating the technical background of the invention, in particular relating to photodetectors for integrated photonic platforms:
[1] S. Yanikgonul et al., "Nature Communications" 12, 1834 (2021); and
[2] IMEC PIX4life, "Silicon nitride photonic integrated circuit prototyping and small volume production" .

Integrated photonics on silicon substrates comprising waveguides made of silicon or silicon nitride has emerged as a transformative technology. Silicon photonic platforms, if they can be fabricated in a foundry, enable low-cost and yet sophisticated integrated photonic circuits to be realized, reducing the cost per chip and the costs of electro-optic systems. Commercially available silicon photonic processes and platforms mostly cater to the infrared telecommunication wavelengths, near 1.3 µm and 1.5 µm. These platforms and the devices therein are enabling new products for data communications and are revolutionizing optical communications.

The visible spectrum offers new, impactful applications, where electro-optic technologies can be used for increasingly prevalent tasks such as micro-displays, imaging, and biosensors. However, new types of foundry and deep-UV lithography compatible silicon photonics platform are required, since the silicon waveguides used in telecom-type of silicon photonic platforms absorb visible light.

One of the indispensable components of fully integrated photonics platforms are photodetectors, which need to provide fast detection speeds and high sensitivity. A main technical challenge in achieving visible-light operation of photodetectors is the optical coupling between a waveguide and a respective photodetector. A much longer coupling length is required to achieve efficient coupling at these wavelengths, resulting in much larger device sizes than required for efficient photon absorption. Additionally, larger device size decreases the bandwidth and increases dark noise due to the larger active volume.

Up to date, [1] is the one of the first publications concerning a photodetector for light in the visible spectrum, utilizing a silicon nitride waveguide end-fire coupled into a silicon-on-insulation mesa for the photodetector design. This design can efficiently launch a maximum portion of the light from the waveguide into the mesa at a photodetector length of 16 µm, achieving a high-speed device performance. However, the end-fire coupling results in a rather high coupling loss of the light of about 1 dB at the waveguide-to-photodetector interface due to mode mismatch and Fresnel reflection.

Commercially, no integrated photonic platforms comprising one or more photodetectors are available, such as the platform design published in [2].

Thus, there is a need for a photodetector apparatus, in particular for light in the visible spectrum and infrared spectrum, with a compact design, providing a high-speed device performance at a short apparatus length, while simultaneously providing a small coupling loss for light coupled from a waveguide to the photodetector apparatus.

### Objective of the invention

An objective of the invention is to provide improved photodetector apparatus and methods for detecting light, avoiding disadvantages of conventional techniques. In particular, detecting light in the visible or infrared spectrum, preferably with a wavelength below 1100 nm, is to be provided with a small coupling loss and/or high-speed device performance. Furthermore, manufacturing the photodetector apparatus is to be facilitated.

### Summary of the invention

The above objective is solved by a photodetector apparatus, being configured for detecting light in the visible or infrared spectrum, and/or a method of detecting light in the visible or infrared spectrum, comprising the features of the independent claims. Advantageous embodiments and applications of the invention are defined in the dependent claims.

According to a first general aspect of the invention, the above objective is solved by a photodetector apparatus, being configured for detecting light in the visible or infrared spectrum. The visible spectrum generally refers to light with a wavelength between 380 nm and 750 nm, and the infrared spectrum refers to light with a wavelength between 750 nm to 2500 nm, preferably below 1500 nm. The photodetector apparatus comprises a substrate, a waveguide, a detector section, a first contact section and a second contact section.

The substrate has a substrate surface and a cladding layer. The waveguide is arranged above the substrate surface in the cladding layer and is adapted for guiding light. The detector section comprises a p-doped region and an n-doped region, and the detector section is arranged for producing charge carriers by the light guided in the waveguide. The first contact section is connected to the p-doped region and the second contact section is connected to the n-doped region, the first and second contact sections being connectable to a measuring device for measuring an electrical signal based on the charge carriers produced by the light.

According to the invention, the waveguide and the detector section are spaced apart by a portion of the cladding layer with a mutual distance such that optical power of the light guided in the waveguide can be gradually transferred from the waveguide to the detector section. Gradually transferring optical power in particular comprises a gradual morphing of the mode (i.e., the light field profile) from one shape in the waveguide into another shape in the detector section along the propagation direction.

According to a second general aspect of the invention, the above objective is solved by a method of detecting light in the visible or infrared spectrum. The method comprises the step of providing a photodetector apparatus according to the first general aspect of the invention or an embodiment thereof. The method further comprises the steps of guiding light in the waveguide of the photodetector apparatus, coupling a portion of the light guided in the waveguide to the detector section of the photodetector apparatus to produce charge carriers in the detector section, and measuring an electrical signal based on the charge carriers produced by the portion of the light.

The photodetector apparatus incorporates the concept of pn- or pin-junction photodiodes, wherein a semiconductor is selectively doped with impurity atoms including donator atoms (n-doped region) and acceptor atoms (p-doped region). Coupling a light field into the detector section results in the generation of pairs of charge carrier that are separated to the p-doped region or the n-doped region and sensed with the first or second contact section, respectively. An electrical signal can be measured via the first and second contact sections based on the charge carriers produced by the light. Separating the charge carrier pairs may be increased by connecting the first and second contact section to an external power source, thus increasing the detection speed and sensitivity.

Furthermore, the photodetector apparatus incorporates the concept of optical coupling along the direction of propagation in the waveguide. Light is confined and guided in a waveguide due to a higher refractive index of its material compared to the surrounding. The evanescent field tails of the optical mode guided in the waveguide extend to the surrounding of the waveguide. ##By controlling the width of the waveguide, which modifies the mode profile, optical power is transferred from the waveguide into the absorbing silicon detector section below.

The inventors found that this transfer of the light has a reduced coupling loss compared with conventional techniques, e. g. according to [1]. Furthermore, the optical coupling method allows the waveguide and the detector section to not be directly connected, but to be spaced apart by a portion of the cladding layer with a mutual distance. This configuration facilitates manufacturing the photodetector apparatus in an advantageous manner.

The spatial range within the photodetector apparatus, where the optical power can be coupled from the waveguide to the detector section is called coupling region. Preferably, the coupling region includes a tapered portion of the waveguide as mentioned below. Advantageously, the sensitivity of the light coupling and the fraction of the light coupled into the detector section are adjustable by selecting the dimensions of the coupling region, e.g., varying the distance between the waveguide and the detector section as well as a length of the coupling region. Along the length of the coupling region, preferably along the longitudinal extension of the waveguide, a gradual transfer of the light from the waveguide into the detector section is obtained.

Furthermore, the inventors found that the reduced coupling loss of the transferred light results in an increased fraction of light absorbed in the detector section. Practical results have shown a maximum absorption efficiency above 96% for light in the visible spectrum. The maximum absorption efficiency can be achieved at a detector section length e. g. below 23 µm for yellow or red light.

As a further advantage, the inventors found that the high-speed performance of the photodetector apparatus is not compromised by the optical coupling along the waveguide in comparison with conventional techniques. The inventors have further found that by choice of voltage bias, the avalanche effect of the electronic carriers can be realized to make an avalanche detector.

The invention can be applied with many visible light photonic applications, e.g., neural probes and quantum optics. In addition, for certain applications such as single-photon avalanche detectors, a higher maximum absorption could reduce the probability of missing the single photon being launched. Hence, the invention can offer technical advantages over the end-fire coupling design of [1] in a substantial number of integrated visible light applications.

According to a preferred embodiment of the invention, a longitudinal direction of the waveguide (e. g. z-direction) is arranged along, in particular parallel to, a longitudinal direction of the detector section. Advantageously, this embodiment allows increasing a length of the coupling region, thus reducing coupling loss. Alternatively, the longitudinal direction of the waveguide may be arranged along, in particular parallel to, a transverse direction of the detector section. The distance between the waveguide and the detector section may be constant along the longitudinal or transverse direction of the detector section. Thus, as an advantage, a constant coupling efficiency is obtained. The distance between the waveguide and the substrate surface may be greater than the thickness of the detector section and/or the distance between an upper surface of the detector section and the substrate surface. The detector section may be arranged between the substrate and the waveguide.

Preferably, the waveguide and the detector section are aligned with each other in a normal direction (e. g. x-direction) perpendicular to the substrate surface (spanned e. g. by x- and y-directions). The mutual distance between the waveguide and the detector section refers to the spacing along the normal direction perpendicular to the substrate surface may be 100 nm or above, preferably between 100 nm and 300 nm.

Advantageously, the inventors found that the alignment of the waveguide and the detector section, i. e. the arrangement of the components one upon the other, increases the optical overlap between the two components, thus enhancing the light transfer from the waveguide to the detector section. The best optical overlap was found for the waveguide being arranged above the detector section, preferably with the longitudinal axis of the waveguide and the longitudinal axis of the detector section being arranged directly above each other.

However, a sufficient light transfer also can be achieved with the waveguide offset in a transverse direction relative to the detector section, preferably wherein the waveguide is arranged at a higher level above the substrate surface than the detector section.

According to another preferred embodiment of the invention, the waveguide comprises a tapered portion being configured for delocalizing the optical fields of the light to be coupled out of the waveguide into the detector section. In the tapered portion, the waveguide has a gradually reduced width (dimension in y-direction). Optionally, a gradually reduced height (dimension in x-direction) can be provided additionally or alternatively. The tapered portion may have a longitudinal extension along the z-direction being restricted to the longitudinal extension of the detector section. The width of the waveguide may be reduced e. g. by half or more in the tapered portion with respect to untapered portions of the waveguide. Due to the gradual reduction of width and/or height of the waveguide, the tapered portion is an adiabatically tapered portion. The width of the tapered portion may be between 150 nm and 250 nm. A length of the tapered portion may be adapted to the length of the detector section. For example, the length of the tapered portion may be 100 µm. Then, along the direction of propagation, over the detector section, light in the top waveguide continues to leak into the detector section due to higher refractive index thereof. Advantageously, there is no phase-matching required between the waveguide and the detector section. The arrangement of the tapered portion relative to the detector section may be shifted (displaced) to engineer the light absorption efficiency in the detector section.

Advantageously, in the photodetector apparatus, light is gradually transferred from the waveguide into the detector section. The tapered portion modifies the optical mode by adiabatically narrowing down the waveguide width before the section of the waveguide aligned to the detector section, preferably wherein the section is arranged above the detector section. The narrower waveguide width provides a weaker fundamental mode confinement in the waveguide. The resulting delocalized light mode, at a given polarization, can facilitate an increased field interaction with the detector section and thus promotes the light absorption into the detector section.

The inventors found that this configuration is particularly useful for shorter visible wavelengths, such as violet and blue light, with an increased mode confinement at a given waveguide width. For example, results have shown that the tapered portion can provide an additional about 36% enhancement in absorption at a waveguide width of 150 nm for transverse electric polarization at λ = 405 nm and at a detector section length of 50 µm, compared to the absorption at a width of 400 nm. A photodetector apparatus with a narrower waveguide can thus have an improved optical responsivity at a shorter detector section to compromise the responsivity-speed trade-off.

Further advantageously, the tapered portion may also enable the waveguide to be made with a greater distance from the detector section (in particular in x-direction), i. e. on a higher level after the detector section has been arranged on the substrate surface. This may result in an easier fabrication of the photodetector apparatus by relaxing the alignment tolerance between the waveguide and the detector section and by giving more flexibility to the material choice used for the waveguide.

According to a further preferred variant of the invention, the waveguide is made of a dielectric that is transparent to light in the visible or infrared spectrum, such as silicon nitride, silicon oxynitride, and/or aluminium oxide. Advantageously, these materials ensure high confinement and minimizing optical losses of the propagating light, providing the desirably high refractive index compared to the material of the substrate and/or the cladding layer. Silicon nitride is particularly preferred, as it is transparent for light in the visible and infrared spectral ranges, in particular below 1100 nm.

The lateral width of the waveguide is selected in dependency on a thickness of the waveguide and the refractive index of the waveguide material. Preferably, the width of the waveguide is above 100 nm, preferably 500 nm or above. The thickness of the waveguide (in x-direction) may be between 100 nm and 200 nm. The waveguide may have a cuboid or cylindrical shape. The distance between the waveguide and the substrate may be, at least in some sections, constant along the waveguide length.

Further advantages of the invention result from the variety of possible arrangements of the detector section relative to the substrate. Each of the arrangements may have particular advantages in terms of manufacturing the photodetector apparatus and setting operation conditions of the detector section.

According to a first variant, the detector section is embedded in the cladding layer. It is enabled that the detector section is not positioned on top of the substrate surface, but a section of the cladding layer is arranged between the detector section and the substrate surface. Alternatively, according to a second variant, the detector section is formed in the substrate, with the p-doped region and the n-doped region being arranged at the substrate surface. According to a third variant, the detector section is formed by a mesa or a rib structure on the substrate, wherein the p-doped region and the n-doped region are arranged in the mesa or the rib structure. The mesa or rib structure may be positioned on top of the substrate surface, i.e., in contact with the substrate surface.

According to an advantageous embodiment of the invention, the detector section comprises a tapered transition region arranged in a longitudinal direction of the detector section. For example, the mesa or the rib structure may comprise a tapered transition region arranged in the longitudinal direction of the detector section. The detector section may comprise a cuboid region and the tapered transition region. The tapered transition region may be tapered with an increasing width towards the cuboid region and/or the first contact section and the second contact section. The first contact section and the second contact section may be connected to an upper surface of the cuboid region. The tapered transition region may comprise a portion adjacent to the cuboid region, the portion comprising a constant width smaller than the width of the cuboid region. A minimum width of the tapered transition region may be about the width of the waveguide.

Advantageously, the tapered transition region of the detector section improves the coupling efficiency between the waveguide and the detector section. Engineering the tapered transition region and the width of a non-tapered region can improve the overlap of the optical field with the detector section.

According to another preferred embodiment of the invention, the p-doped region and the n-doped region are arranged at an upper surface of the detector section. The p-doped region and the n-doped region may be arranged at a surface of the detector section facing the waveguide. Preferably, a boundary between the p-doped region and the n-doped region may be arranged along a longitudinal or transverse axis of the detector section. Further preferably, the p-doped region and the n-doped region may be arranged symmetrically in the detector section, in particular with respect to a longitudinal and/or transverse axis of the detector section. The p-doped region and the n-doped region may have the same dimensions, such as the same width and length. The p-doped region may have a p-doping concentration of e. g. 10¹⁶ - 10²⁰ cm⁻³. The n-doped region may have a n-doping concentration of e. g. 10¹⁶ - 10²⁰ cm⁻³. A distance between the p-doped region and the n-doped region may be between 0 and 4 µm.

Advantageously, the inventors found that the above arrangement of the doped regions and doping concentrations are particularly favorable for the responsivity and detection efficiency of the photodetector apparatus, specifically for detecting light in the visible or infrared spectrum.

According to further preferred variants of the invention, the p-doped region and the n-doped region may be arranged at at least one sidewall of the detector section and/or at least one region on the substrate surface adjacent to the detector section. Preferably, this is provided additionally to the arrangement at the upper surface of the detector section. As an alternative to the region on the substrate surface, the p-doped region and the n-doped region may be additionally arranged at at least a region in the cladding layer adjacent to the detector section.

Advantageously, doping the sidewall of the detector section and/or regions adjacent to the detector section results in a more efficient collection of the charge carriers generated in the detector section, thus, improving the responsivity of the photodetector apparatus.

According to another preferred embodiment of the invention, the p-doped region and the n-doped region are separated by an intrinsic region. Alternatively or in addition, doping and/or bias conditions (e. g. provided by connecting the detector section with a bias voltage source) are optimized for operating the photodetector apparatus in an avalanche mode.

Advantageously, the provision of the additional intrinsic region increases the detection speed, as charge carriers that are generated in the intrinsic region are separated due to the electric field across the region and are accelerated to the p-doped and n-doped regions. Simultaneously, the intrinsic region increases responsivity, as the volume where photons are absorbed is enlarged. Further advantageously, the doped regions and/or the applied voltage or current may be modified in a known manner to operate the photodetector apparatus in avalanche mode. In the avalanche mode, the charge carriers are additionally accelerated by an electric bias field, so that they generate secondary charge carriers by impact ionization, thus increasing the measurable electric signal depending on the light absorbed by the detector section. For example, a reverse bias may be applied by connecting the first contact section to a negative terminal of an external voltage source and the second contact section to the positive terminal of the external voltage source, and/or an additionally doped region may be arranged, such as an additional less doped p-doped region arranged between the n-doped region and the intrinsic region. Accordingly, the detection efficiency of the photodetector apparatus can be increased.

According to another preferred embodiment of the invention, the p-doped region is split into at least two p-doped sub-regions with a first p-doped sub-region comprising a higher p-doping concentration than a second p-doped sub-region. Alternatively or in addition, the n-doped region is split into at least two n-doped sub-regions with a first n-doped sub-region comprising a higher n-doping concentration than a second n-doped sub-region. The first p-doped region may have a p-doping concentration of 10¹⁶ - 10¹⁸ cm⁻³, and the second p-doped region may have a p-doping concentration of 10¹⁸ - 10²⁰ cm⁻³. The first n-doped region may have a n-doping concentration of 10¹⁶- 10¹⁸ cm⁻³, and the second n-doped region may have a n-doping concentration of 10¹⁸ - 10²⁰ cm⁻³. A distance between the first p-doped sub-region and the first n-doped sub-region may be between 0 and 4 µm, a distance between the second p-doped sub-region and the second n-doped sub-region may be between 0 and 2 µm . Advantageously, doped regions sandwiched between higher doped regions result in increased detection speed.

Preferably, the substrate of the photodetector apparatus is made of silicon or it is a silicon-on-insulator substrate, such as a silicon wafer. Advantageously, a silicon-on-insulator substrate may improve an overlap of the optical field of the light guided in the waveguide with the silicon for a higher photodetector responsivity. The design comprising a silicon-on-insulator substrate may also benefit from a thinner silicon layer compared to a bulk silicon substrate which leads to higher speed performance.

Furthermore, the detector section may be made of the same material like the substrate. Preferably, the detector section is made of silicon. Furthermore, a width of the detector section may be chosen so that first and second contact sections can be connected to the p-doped region and the n-doped region, respectively. Preferably, the width of the detector section may be above 10 µm, preferably 50 µm or above. A length of the detector section is selected for providing the coupling region, in particular in dependency on the position of the waveguide relative to the detector section, the width and thickness of the waveguide, and the resulting optical overlap of the waveguide with the absorbing detector section. Preferably, the length of the detector section may be between 25 µm and 500 µm. A thickness of the detector section may be above 2 µm , preferably between 2.5 µm and 3 µm. In case that the detector section is formed by a rib structure, a rib height of the rib structure may be between 100 nm and 500 nm. Advantageously, the inventors found that the given dimensions of the detector section are particularly favorable for detecting light in the visible or infrared spectrum.

The waveguide is encapsulated by the cladding layer. Preferably, the material of the cladding layer has a smaller refractive index than the material of the waveguide in order to support the confinement of light propagating through the waveguides. Preferably, the cladding layer is made of silicon dioxide (SiO₂).

The first contact section and the second contact section are preferably arranged above the substrate surface in the cladding layer. A first end of the first contact section is connected to the p-doped region and a first end of the second contact section is connected to n-doped region. A second end of the first contact section and a second end of the second contact section are connectable to the measuring device for measuring an electrical signal based on the charge carriers produced by the light. The second ends may be exposed to a surrounding of the photodetector apparatus and/or may be arranged outside of the cladding layer. In addition to the measuring device, the first contact section and the second contact section may be connectable to an external voltage source or external current source. The first contact section and the second contact section may be connectable to the measuring device and/or the external voltage source and/or the external current source to form a closed electric circuit. The first contact section and the second contact section may be made of metal.

According to another preferred embodiment of the invention, an input end of the waveguide is optically coupled to a light source being arranged for producing a light with a wavelength in the visible or infrared spectrum, preferably below 1100 nm. The light source device may emit light with a wavelength in the visible spectrum (380 nm to 750 nm), the infrared spectrum (750 nm to 2500 nm) and/or a wavelength range covering a portion of the visible and/or infrared spectra, e. g., below 1100 nm. As an alternative to the light source device, an external light source not part of the photodetector apparatus can be provided for performing the method of detecting light.

According to another advantageous embodiment of the invention, the photodetector apparatus is provided in an integrated photonic platform, e. g. an integrated solid chip including the components of the photodetector apparatus. Advantageously, integrated photonic platforms enable fabrication of a large number of photonic components on a single chip, resulting in a minimization of many conventional optical systems, which in turn results in reduced cost, scalability and higher yield. Accordingly, the components of the photodetector apparatus can be advantageously arranged on a single chip, thus enabling detecting light in the integrated photonic platform.

Features disclosed in the context of the photodetector apparatus and the embodiments thereof also represent preferred features of the inventive method of detecting light in the visible or infrared spectrum and the embodiments thereof, and vice versa. The aforementioned aspects and inventive and preferred features, in particular with regard to the configuration of the photodetector apparatus as well as the dimensions and compositions of individual components which have been described in relation to the photodetector apparatus, therefore also apply for the method. The preferred embodiments, variants and features of the invention described above are combinable with one another as desired.

### Brief description of the drawings

Further details and advantages of the invention are described with reference to the attached drawings, which show in
- Figure 1:: a cross-section-view illustration of a first embodiment of a photodetector apparatus;
- Figure 2:: a top-view illustration of the first embodiment of the photodetector apparatus;
- Figure 3:: a top-view illustration of a second embodiment of the photodetector apparatus;
- Figure 4:: a top-view illustration and cross-section-view illustrations of a third embodiment of the photodetector apparatus;
- Figure 5:: a top-view illustration and cross-section-view illustrations of a fourth embodiment of the photodetector apparatus; and
- Figure 6:: a flowchart illustrating a method according to an embodiment of the invention.

### Description of preferred embodiments

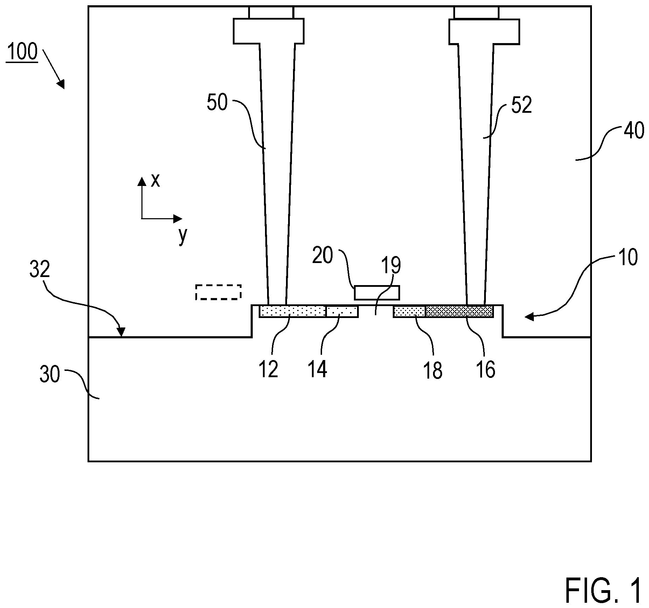

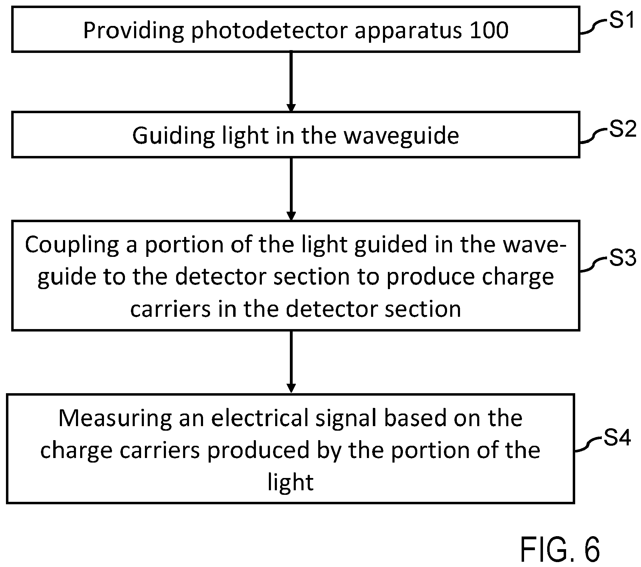

Features of preferred embodiments of the invention are described in the following with reference to the design of the photodetector apparatus as illustrated in Figures 1 to 5, and the method of the invention as illustrated in Figure 6. It is noted that the implementation of the invention is not restricted to the components and method steps described in an exemplary manner. For instance, embodiments of the invention can be modified with regard to the dimensions, positions and/or materials of the waveguide and the detector section, including the p-doped and n-doped regions, in particular with the dimension and doping ranges noted above. The mutual distance between the waveguide and the detector section, e. g. the spacing along the normal direction perpendicular to the substrate surface, to be provided for a particular application of the invention can be selected on the basis of numerical simulations of the gradual transfer of optical power of the light from the waveguide to the detector section or by experimental tests. The photodetector apparatus is manufactured with semiconductor processing (e. g. deposition, structuring, doping, etching) methods which are known per se.

Exemplary reference is made to Cartesian coordinates, wherein the substrate extends in an x-y-plane and the waveguide and the detector section extend in a z-direction. The length of components refers to the extension in z-direction, while the width and height refer to the y- and x-directions, resp..

The drawings are schematic illustrations, mainly for showing the inventive concept of the photodetector apparatus. In practice, the shape and size of the illustrated components can be selected and adapted in dependency on particular application requirements. For instance, the dimensions of the detector section, including the p-doped and n-doped regions, and the arrangement of the waveguide and the detector section to each other can be adapted for the desired wavelength range of the light coupled from the waveguide to the detector section, in particular light in the visible and infrared spectrum. Details described with reference to one of the illustrated embodiments, e.g., regarding the photodetector apparatus, can be employed with other embodiments in a corresponding manner.

The drawings show one photodetector on a substrate. In practice, multiple photodetectors can be arranged on the substrate. In particular, a photonic platform may comprise one chip providing the substrate and carrying a plurality of waveguides and detector sections. Alternatively or additionally, two or more detector sections can be arranged along one waveguide.

Figure 1 schematically shows a cross-sectional view (perpendicular to the z-direction) of the first embodiment of the photodetector apparatus 100 being configured for detecting light in the visible or infrared spectrum. The photodetector apparatus 100 comprises a substrate 30 having a substrate surface 32 and a cladding layer 40.

For example, the substrate 30 may be made of silicon or may be a silicon-on-insulator substrate, the cladding layer 40 may be made of silicon dioxide. The photodetector apparatus 100 further comprises a waveguide 20, a detector section 10, a first contact section 50 and a second contact section 52.

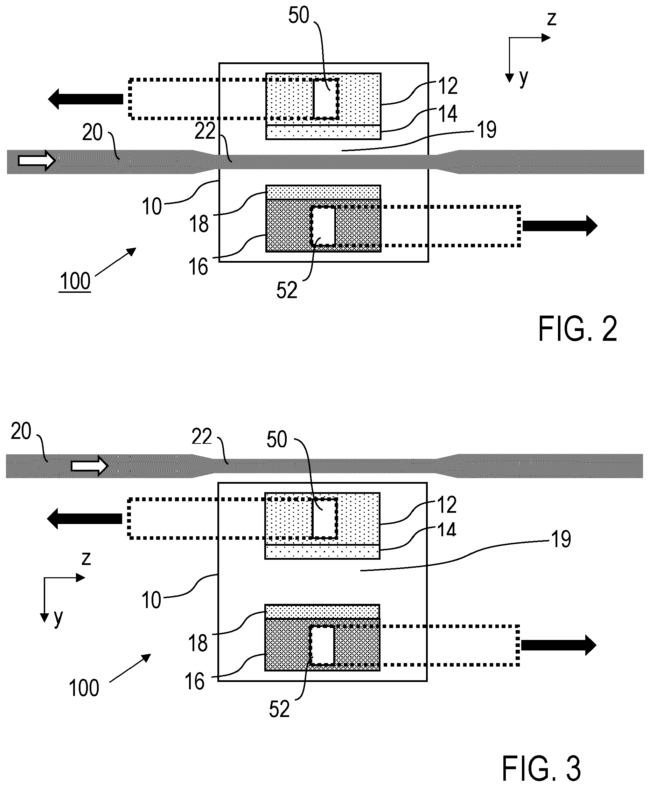

The waveguide 20 is arranged in x-direction above the substrate surface 32 in the cladding layer 40 and it is adapted for guiding light. The waveguide 20 may be made of a dielectric material transparent to light in the visible or infrared spectrum, such as silicon nitride, silicon oxynitride, and/or aluminium oxide. An input end of the waveguide 20 may be optically coupled to a light source (not shown) being arranged for producing a light with a wavelength in the visible or infrared spectrum, preferably below 1100 nm. The waveguide 20 is arranged directly above the detector section 20, i. e. it is aligned with the detector section along a direction perpendicular to the substrate surface 32. Additionally, the waveguide 20 is arranged at a higher level above the substrate surface 32 than the detector section 10. Alternatively, the waveguide 20 can be arranged offset in a transverse direction (y-direction) relative to the detector section 10 (as illustrated with the dashed box, see second embodiment shown in Figure 3).

The detector section 10 comprises a p-doped region 12, 14 and an n-doped region 16, 18 with an intrinsic region 19 therebetween. The detector section 10 is arranged for producing charge carriers in the detector section 10 by the light guided in the waveguide 20. The waveguide 20 and the detector section 10 are in close proximity, but not connected to each other. Instead, the waveguide 20 and the detector section 10 are spaced apart by a portion of the cladding layer 40 with a mutual distance such that evanescent fields of the light can be coupled from the waveguide 20 to the detector section 10.

The first contact section 50 and the second contact section 52 are arranged above the substrate surface 32 in the cladding layer 40. One end of the first contact section 50 is connected to the p-doped region 12, 14 and one end of the second contact section 52 is connected to n-doped region 16, 18. Another end of the first and second contact sections 50, 52 are accessible from a surrounding of the photodetector apparatus 100 and connectable to a measuring device (not shown) for measuring an electrical signal based on the charge carriers produced by the light. In addition to the measuring device, the first contact section and the second contact section may be connectable to an external voltage source or external current source (not shown).

In a practical implementation, the width of the waveguide 20 is e. g. 500 nm and reduced in the tapered section (length about 100 µm) to about 150 to 250 nm. The length of the detector section is selected e. g. in a range from 50 µm to 500 µm.

Figure 2 schematically shows a top-view illustration of the first embodiment of the photodetector apparatus 100. A longitudinal direction of the waveguide 20 is arranged parallel to a longitudinal direction of the detector section 10. Other arrangements of the waveguide 20 and the detector section 10 may be possible, as long evanescent fields of the light guided in the waveguide 20 can be coupled from the waveguide 20 to the detector section 10.

The p-doped region 12, 14 and the n-doped region 16, 18 are arranged symmetrically in the detector section, in particular with respect to a longitudinal axis of the detector section 20 and a plane perpendicular to the substrate 30.

Furthermore, the waveguide 20 comprises a tapered portion 22 being configured for delocalizing the evanescent fields of the light coupled out of the waveguide 20 to the detector section 10. In this embodiment, the tapered portion 22 has a longitudinal extension adapted to the length of the detector section 10. The tapered portion 22 of the waveguide 20 is arranged directly above the detector section 10, specifically above the intrinsic region 19, wherein the longitudinal extension of the tapered portion 22 is restricted to the extension of the detector section 10.

The dotted boxes illustrate electrical connections to the first and second contact sections 50, 52, such as electrical connections to the measuring device. The black arrows illustrate signals corresponding to the charge carriers produced by the light coupled from the waveguide 20 to the detector section 10, measurable by the measuring device. The white arrow at one end of the waveguide 20 illustrates the direction of the light propagating through the waveguide 20.

Figure 3 schematically shows a top-view illustration of the second embodiment of the photodetector apparatus 100. In comparison to the first embodiment, the waveguide 20 it is arranged offset from the detector section 10. Specifically, with reference to a direction perpendicular to the substrate surface 32, the waveguide 20 and the detector section 10 are displaced relative to each other.

As with the first embodiment, the detector section 10 is arranged between the waveguide 20 and the substrate surface 32, with the longitudinal axis of the waveguide 20 being parallel to with the longitudinal axis of the detector section 10. The tapered portion 22 of the waveguide 20 is arranged displaced from the detector section 10, specifically from the intrinsic region 19 thereof, wherein the longitudinal extension of the tapered portion 22 is restricted to the extension of the detector section 10.

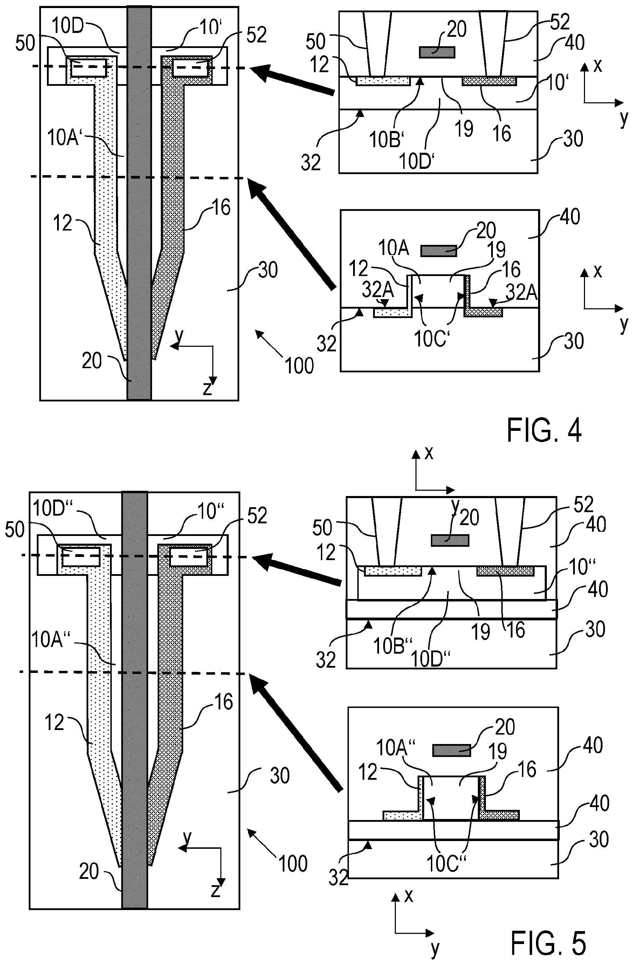

Figure 4 schematically shows a top-view (left) and cross sectional views (right) of the third embodiment of the photodetector apparatus 100. In comparison to the detector section 10 of the first and second embodiments, the detector section 10' of the third embodiment is formed by a mesa on the substrate 30, wherein the p-doped region 12, 14 and the n-doped region 16, 18 are arranged in the mesa. As an alternative to the mesa, the detector section 10' may also be formed by a rib structure.

The left illustration of Figure 4 shows that the detector section 10' comprises a tapered transition region 10A' and a cuboid region 10D'. The cuboid region 10D' extends in y-direction, i. e. across the longitudinal direction of the detector section 10', and it is arranged for contacting the detector section 10'. The first contact section 50 and the second contact section 52 are connected to an upper surface of the cuboid region 10D'. The cuboid region 10D' is designed to be wide enough for the contact sections and is e. g. about 50 µm. The tapered transition region 10A' is arranged in longitudinal direction of the detector section 10'.

The upper right illustration of Figure 4 shows a cross-section of the cuboid region 10D' of the detector section 10' and the lower right illustration shows a cross-section of the tapered transition region 10A'. The p-doped region 12, the n-doped region 16 and the intrinsic region 19 are arranged at an upper surface 10B' of the detector section 10'. Additionally, the p-doped region 12 and the n-doped region 16 may be arranged at a sidewall 10C' of the detector section 10', specifically of the tapered transition region 10A, and/or in a region 32A' on the substrate surface 32 adjacent to the detector section 10'. Furthermore, the p-doped region 12 and the n-doped region 16 may comprise at least two sub-regions with different doping concentrations.

Figure 5 schematically shows a top view and a cross sectional view of the fourth embodiment of the photodetector apparatus 100. In comparison to the detection sections 10, 10' of the first to third embodiment, the detector section 10" of the fourth embodiment is embedded in the cladding layer 40.

Similar to the detector section 10' of the third embodiment, the detector section 10" comprises a cuboid region 10D" and a tapered transition region 10A", which is arranged in longitudinal direction of the detector section 10", as shown in the left illustration of Figure 5.

The upper right illustration of Figure 5 shows a cross-section of the cuboid region 10D" of the detector section 10" and the lower right illustration shows a cross-section of the tapered transition region 10A". Both illustrations show that the detector section 10" is not arranged directly on top of the substrate surface 32, but a section of the cladding layer 40 is arranged between the detector section 10" and the substrate surface 32.

Furthermore, the p-doped region 12, the n-doped region 16 and the intrinsic region 19 are arranged at an upper surface 10B" of the detector section 10". Additionally, the p-doped region 12 and the n-doped region 16 may be arranged at a sidewall 10C'" of the detector section 10", specifically of the tapered transition region 10A", and/or a region 32A in the cladding layer 40 adjacent to the detector section 10".

Features of embodiments of a method of detecting light in the visible or infrared spectrum according to the invention are illustrated in Figure 6. Exemplary reference is made to employing the photodetector apparatus 100, e. g. as shown in the Figures.

With step S1, the photodetector apparatus 100 according to the invention is provided, for example the photodetector apparatus 100 in accordance to the first embodiment shown in Figures 1 and 2.

With step S2, light to be detected is guided in the waveguide 20 of the photodetector apparatus 100. The light, preferably with a wavelength in the visible or infrared spectrum below 1100 nm, may be produced by a light source optically coupled to an input end of the waveguide 20 or another emitter, e. g. of an experimental setup.

With step S3, a portion of the light guided in the waveguide 20 is coupled to the detector section 10 of the photodetector apparatus 100 to produce charge carriers in the detector section 10. For example, evanescent fields of the light entering the tapered portion 22 of the waveguide 20 are delocalized and coupled out of the waveguide 20 to the detector section 10.

The light transferred from the waveguide 20 to the detector section 10 is absorbed by the detector section, resulting in the production of charge carrier pairs, in particular in the intrinsic region 19, if the energy of the absorbed light is large enough. The charge carrier pairs are separated and moved, in particular accelerated, via the p-doped region 12, 14 and the n-doped region 16, 18 towards the first and second contact sections 50, 52, respectively. The electric field in the detector section 10 may be increased by additionally connecting the first and second contact section 50, 52 to an external voltage source or current source.

Finally, with step 4, an electrical signal based on the charge carriers produced by the portion of the light is measured by the measuring device connected to the first and second contact sections 50, 52.

The features of the invention disclosed in the above description, the drawings and the claims can be of significance individually, in combination or sub-combination for the implementation of the invention in its different embodiments.

## Claims

1. Photodetector apparatus (100), being configured for detecting light in the visible or infrared spectrum, comprising
- a substrate (30) having a substrate surface (32) and a cladding layer (40),
- a waveguide (20) being arranged above the substrate surface (32) in the cladding layer (40) and being adapted for guiding light,
- a detector section (10; 10'; 10") comprising a p-doped region (12, 14) and a n-doped region (16, 18) and being arranged for producing charge carriers by the light guided in the waveguide (20), and
- a first contact section (50) connected to the p-doped region (12, 14) and a second contact section (52) connected to n-doped region (16, 18), the first and second contact sections (50, 52) being connectable to a measuring device for measuring an electrical signal based on the charge carriers produced by the light,
**characterized in that**
- the waveguide (20) and the detector section (10; 10'; 10") are spaced apart by a portion of the cladding layer (40) with a mutual distance such that optical power of the light guided in the waveguide (20) can be gradually transferred from the waveguide (20) to the detector section (10; 10'; 10").

2. Photodetector apparatus (100) according to claim 1, wherein
- a longitudinal direction of the waveguide (20) is arranged along, in particular parallel to, a longitudinal direction of the detector section (10; 10'; 10").

3. Photodetector apparatus (100) according to one of the foregoing claims, wherein
- the waveguide (20) and the detector section (10; 10'; 10") are aligned with each other in a direction perpendicular to the substrate surface (32).

4. Photodetector apparatus (100) according to one of the foregoing claims, wherein
- the waveguide (20) comprises a tapered portion (22) being configured for delocalizing optical fields of the light guided in the waveguide (20) so that the optical power is coupled out of the waveguide (20) into the detector section (10; 10'; 10") along the direction of propagation.

5. Photodetector apparatus (100) according to claim 4, wherein
- the tapered portion (22) has a longitudinal extension restricted to the extension of the detector section (10; 10'; 10").

6. Photodetector apparatus (100) according to one of the foregoing claims, wherein
- the detector section (10") is embedded in the cladding layer (40).

7. Photodetector apparatus (100) according to one of the claims 1 to 5, wherein
- the detector section (10) is formed in the substrate (30), the p-doped region (12, 14) and the n-doped region (16, 18) being arranged at the substrate surface (32).

8. Photodetector apparatus (100) according to one of the claims 1 to 5, wherein
- the detector section (10') is formed by a mesa or a rib structure on the substrate (30), wherein the p-doped region (12, 14) and the n-doped region (16, 18) are arranged in the mesa or the rib structure.

9. Photodetector apparatus (100) according to one of the foregoing claims, wherein
- the detector section (10; 10'; 10") comprises a tapered transition region (10A; 10A', 10A") arranged in a longitudinal direction of the detector section (10; 10'; 10").

10. Photodetector apparatus (100) according to one of the foregoing claims, wherein
- the p-doped region (12, 14) and the n-doped region (16, 18) are arranged at an upper surface (10B; 10B') of the detector section (10; 10'; 10"), preferably with a boundary between the p-doped region (12, 14) and the n-doped region (16, 18) being arranged along a longitudinal or transverse axis of the detector section (10; 10'; 10").

11. Photodetector apparatus (100) according to claim 10, wherein
- the p-doped region (12, 14) and the n-doped region (16, 18) are arranged at a sidewall (10C; 10C') of the detector section (10; 10'; 10") and/or at least a region (32A) on the substrate surface (32) adjacent to the detector section (10; 10'; 10").

12. Photodetector apparatus (100) according to one of the foregoing claims, wherein
- the p-doped region (12, 14) and the n-doped region (16, 18) are separated by an intrinsic region (19), and/or
- doping and/or bias conditions are optimized for operating the photodetector apparatus (100) in an avalanche mode.

13. Photodetector apparatus (100) according to one of the foregoing claims, wherein
- the p-doped region (12, 14) is split into at least two p-doped sub-regions with a first p-doped sub-region (12) comprising a higher p-doping concentration than a second p-doped sub-region (14), and/or
- the n-doped region (16, 18) is split into at least two n-doped sub-regions with a first n-doped sub-region (16) comprising a higher n-doping concentration than a second n-doped sub-region (18).

14. Photodetector apparatus (100) according to one of the foregoing claims, comprising at least one of the features:
- the p-doped region (12, 14) has a p-doping concentration of 10¹⁶-10²⁰ cm⁻³,
- the n-doped region (16, 18) has a n-doping concentration of 10¹⁶-10²⁰ cm⁻³,
- a distance between the p-doped region (12, 14) and the n-doped region (16, 18) is between 0 and 4 µm,
- the substrate (30) is made of silicon or is a silicon-on-insulator substrate,
- the waveguide (20) is made of a dielectric transparent to light in the visible or infrared spectrum, such as silicon nitride, silicon oxynitride, and/or aluminium oxide
- a width of the detector section (10; 10'; 10") is above 10 µm, preferably 50 µm or above,
- a length of the detector section (10; 10'; 10") is between 25 µm and 500 µm,
- a thickness of the detector section (10; 10'; 10") is above 2 µm , preferably between 2.5 µm and 3 µm ,
- a rib height of the rib structure is between 100 nm and 500 nm,
- a width of the waveguide (20) is above 100 nm, preferably 500 nm or above, and
- a distance between the waveguide (20) and the detector section (10; 10'; 10") in a direction perpendicular to the substrate surface (32) is 100 nm or above, preferably between 100 nm and 300 nm.

15. Photodetector apparatus (100) according to one of the foregoing claims, wherein
- an input end of the waveguide (20) is optically coupled to a light source being arranged for producing a light with a wavelength in the visible or infrared spectrum below 1100 nm.

16. Photodetector apparatus (100) according to one of the foregoing claims, wherein
- the photodetector apparatus (100) is provided in an integrated photonic platform.

17. Method of detecting light in the visible or infrared spectrum, comprising the steps of
- providing a photodetector apparatus (100) according one of the claims 1 to 16,
- guiding light in the waveguide (20) of the photodetector apparatus (100),
- coupling a portion of the light guided in the waveguide (20) to the detector section (10; 10'; 10") of the photodetector apparatus (100) to produce charge carriers in the detector section (10; 10'; 10"), and
- measuring an electrical signal based on the charge carriers produced by the portion of the light.
